# EUROPÄISCHE PATENTSCHRIFT

(11) **EP 2 421 102 B1**
(45) Veröffentlichungstag und Bekanntmachung des Hinweises auf die Patenterteilung: **06.06.2018**
(21) Anmeldenummer: 10173456.4
(22) Anmeldetag: 19.08.2010
(51) Int. Cl.: H01R 43/28, H01L 23/00, H01R 43/052

(54) **Vorrichtung und Verfahren zum Bilden einer Kabelschlaufe**
Device and method for forming a cable lug
Dispositif et procédé destinés à la formation d'une boucle de câble

(43) Veröffentlichungstag der Anmeldung: 22.02.2012
(73) Patentinhaber: Komax Holding AG, 6036 Dierikon (CH)
(72) Erfinder: Eggimann, Reto, 6023 Rothenburg (CH); Braun, Fredi, 6330 Cham (CH)
(74) Vertreter: Inventio AG

(56) Entgegenhaltungen:
- EP-A1- 1 691 457
- EP-A2- 1 032 095
- FR-A1- 2 491 691
- GB-A- 2 193 124
- US-A- 3 813 862
- US-A- 4 631 911

## Beschreibung

Die Erfindung betrifft eine Vorrichtung und ein Verfahren zum Bilden einer Kabelschlaufe, gemäss der Definition der unabhängigen Patentansprüche. Eine solche Vorrichtung kann zum Beispiel Teil einer Kabelbearbeitungsmaschine sein.

Insbesondere geht es um das Ausformen von Kabelschlaufen bei Kabelbearbeitungsmaschinen. Dabei werden mit Stücken des zu bearbeiteten Kabels Schlaufen gebildet, die typischerweise an beiden Enden gehalten und zu Bearbeitungsstationen transportiert werden. Da die Kabel in der Regel von einer Rolle oder Trommel, oder aus Fässern zugeführt werden, baut sich im Kabel beim Einziehen oder Einbringen in die Kabelbearbeitungsmaschine Drall auf, der ein Überwerfen (Verdrehen) der Kabelschlaufen bewirkt, wenn diese an beiden Enden festgehalten werden.

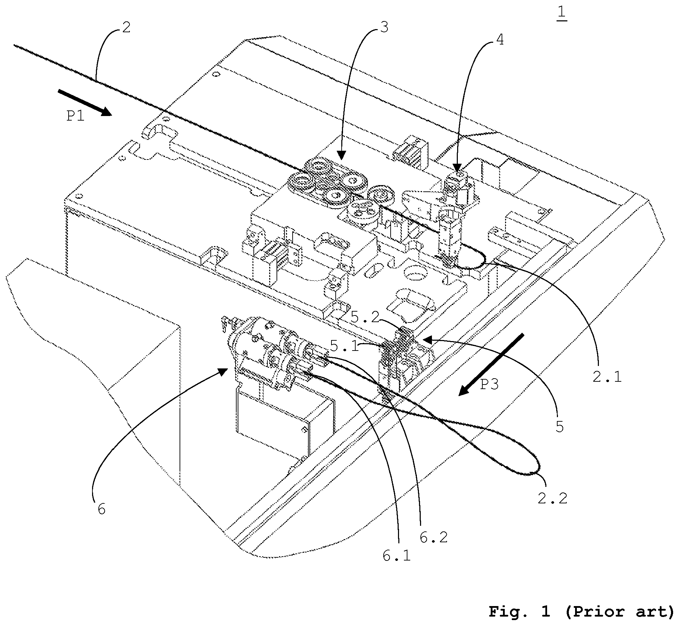

Typischerweise wird in einer solchen Kabelbearbeitungsmaschine 1, die in Fig. 1 anhand eines Beispiels gezeigt ist, das Kabel 2 von einer Rolle oder Trommel abgewickelt, oder aus einem Fass (nicht dargestellt) zugeführt. Ein Kabelantrieb 3 zieht das Kabel 2 in die Kabelbearbeitungsmaschine 1. Die entsprechende Bewegungsrichtung ist in Fig. 1 durch den Pfeil P1 angedeutet. Es kommt ein Schlaufenleger 4 zum Einsatz, der aus einem vorgegebenen Längenabschnitt des Kabels 2 eine Schlaufe 2.1 bildet. Dabei ergreift der Schlaufenleger 4 das vorauseilende Kabelende des Kabels 2 und bildet durch eine Drehbewegung die Schlaufe 2.1, die durch weiteren Vorschub des Kabels 2 auf die gewünschte Länge gebracht wird. Der Beginn dieses Prozesses ist in Fig. 1 gezeigt. Die Schlaufe 2.1 ist hier noch sehr klein.
Nach einem Abtrennen der Schlaufe 2.1 übernimmt eine Transfereinheit 5, wie zum Beispiel aus der Patentanmeldung EP1073163-A1 bekannt, die beiden Enden der Schlaufe 2.1 und bringt sie durch eine Querbewegung in Richtung P3 zu einer sogenannten Entdrillvorrichtung 6.
Aus der Patentanmeldung EP1691457-A1 ist eine entsprechende Kabelbearbeitungsmaschine 1 mit Schlaufenleger 4, Transfereinheit 5 und Entdrillvorrichtung 6 bekannt, die es erlaubt, den Drall aus einer Kabelschlaufe 2.1 zu entfernen. Dies geschieht hier mit einer Entdrillvorrichtung 6, die mit zwei drehbaren Kabelgreifern 6.1, 6.2 ausgerüstet ist, die in dem in Fig. 1 gezeigten Moment eine zweite Kabelschlaufe 2.2 halten. Der Drall in dieser zweiten Kabelschlaufe 2.2 wird entfernt, indem mindestens einer der beiden Kabelgreifer 6.1, 6.2 Entdrilldrehungen um einen bestimmten Wert entgegen der Drallrichtung der Kabelschlaufe 2.2 um eine Horizontalachse ausführt.
Es ist ein Nachteil dieses Ansatzes, dass die Richtung und der Winkel dieser Entdrilldrehbewegung vorgängig durch Versuche bestimmt und abgespeichert werden muss. Nachteilig ist dabei auch, dass diese Werte sich über die Länge des der Kabelbearbeitungsmaschine 1 zugeführten Kabels 2 nicht immer konstant sind und es insbesondere bei langen Kabelschlaufen nicht in jedem Fall gelingt, den Drall zu entfernen, da sich die Schlaufen mehrfach und ungünstig überwerfen können.

Aus der GB2193124 A und der FR2491691 A1 ist eine Kabelbearbeitungsmaschine mit einem Rundtisch und einem quer zum Rundtisch bewegbaren Haken bekannt geworden, bei welcher ein von einem Kabelvorrat abgezogenes und auf einer Seite am Rundtisch fixiertes Kabel etwa mittig vom Haken erfasst wird und zur Schlaufenbildung mittels des Kabels heraus gezogen wird.

Es stellt sich daher die Aufgabe eine Lösung bereit zu stellen, die es ermöglicht, ein Bilden einer Kabelschlaufe zu vereinfachen.

Es hat sich gezeigt, dass das Überwerfen der Kabelschlaufen eines der Hauptprobleme darstellt.

Diese Aufgabe wird durch das kennzeichnete Teil der Vorrichtung aus Anspruch 1 und nach dem Verfahren aus Anspruch 7 gelöst. Gemäss Erfindung wird das Überwerfen der Kabelschlaufen verhindert, indem das Kabel während der Schlaufenbildung mit einem Auszugsgreifer gehalten und optional auch ausgezogen wird. Der Drall in der Schlaufe und/oder der drallfreie Zustand durch eine Sensoreinrichtung ermittelt. Der Auszugsgreifer ist gemäss einer Ausführungsform vorzugsweise so ausgebildet, dass er die Richtung des Dralls in der Schlaufe und/oder den drallfreien Zustand der Schlaufe erkennen kann. Eine weitere Ausführungsform umfasst einen Auszugsgreifer, der den Drall einer Schlaufe und/oder den drallfreien Zustand der Schlaufe erkennen kann, und eine Sensorvorrichtung.
Vorzugsweise werden die beiden Kabelenden bei gestreckter Schlaufe einer Entdrillvorrichtung nach EP1691457-A1 übergeben, welche entsprechend der vom Auszugsgreifer und/oder der Sensoreinrichtung bestimmten Richtung das Entdrillen durchführt, bis der Auszugsgreifer und/oder die Sensoreinrichtung den drallfreien Zustand der Schlaufe erkennt.

Die erfindungsgemässe Vorrichtung eignet sich besonders für eine Kabelbearbeitungsmaschine nach EP1691457-A1. Vorteilhafte Weiterbildungen der Erfindung sind in den abhängigen Patentansprüchen angegeben.

Anhand der beiliegenden Figuren wird die vorliegende Erfindung näher erläutert.

Es zeigen:
Fig. 1 Eine perspektivische Ansicht eines Teils einer vorbekannten Kabelbearbeitungsmaschine;
Fig. 2A Eine perspektivische Ansicht eines Teils einer Vorrichtung mit Auszugsgreifer in einer ersten Momentaufnahme;
Fig. 2B Eine perspektivische Ansicht des Teils der Vorrichtung mit Auszugsgreifer nach Fig. 2A in einer zweiten Momentaufnahme;
Fig. 3A Eine perspektivische Ansicht eines Teils des Auszugsgreifer in einem geöffneten Zustand beim Greifen oder Loslassen einer Kabelschlaufe;
Fig. 3B Eine perspektivische Ansicht des Auszugsgreifer nach Fig. 3A in einem geschlossenen Zustand mit einer umschlossenen Kabelschlaufe;
Fig. 3C Eine Seitenansicht des Auszugsgreifer nach Fig. 3A im geschlossenen Zustand, wobei die Kabelschlaufe nicht gezeigt ist;
Fig. 3D Eine perspektivische Ansicht des Auszugsgreifer nach Fig. 3A in einer Schrägstellung in einem geschlossenen Zustand, wobei die Kabelschlaufe nicht gezeigt ist;
Fig. 3E Eine Rückansicht des Auszugsgreifer nach Fig. 3A, in der zwei optionale Lichtschranken gezeigt sind;
Fig. 4A Eine stark schematisierte Prinzipskizze einer Kabelbearbeitungsmaschine beim Einbringen eines Kabelabschnitts;
Fig. 4B Eine stark schematisierte Prinzipskizze der Kabelbearbeitungsmaschine nach Fig. 4A beim Bilden einer Kabelschlaufe und nach dem Umgreifen der Kabelschlaufe mit dem Auszugsgreifer;
Fig. 4C Eine stark schematisierte Prinzipskizze der Kabelbearbeitungsmaschine nach Fig. 4A nach dem Ausziehen der Kabelschlaufe;
Fig. 4D Eine stark schematisierte Prinzipskizze der Kabelbearbeitungsmaschine nach Fig. 4A nach der Übergabe der Kabelschlaufe an eine Transfereinheit; und
Fig. 4E Eine stark schematisierte Prinzipskizze der Kabelbearbeitungsmaschine nach Fig. 4A nach dem Ausführen einer Transferbewegung und vor der Übergaben der Kabelschlaufe von der Transfereinheit an einer Entdrillvorrichtung.

Die Erfindung wird im Folgenden anhand einer Ausführungsform beschrieben, die auf einer Kabelbearbeitungsmaschine 1 nach EP1691457-A1 aufbaut. Die Erfindung lässt sich aber auch auf andere Kabelbearbeitungsmaschinen übertragen.

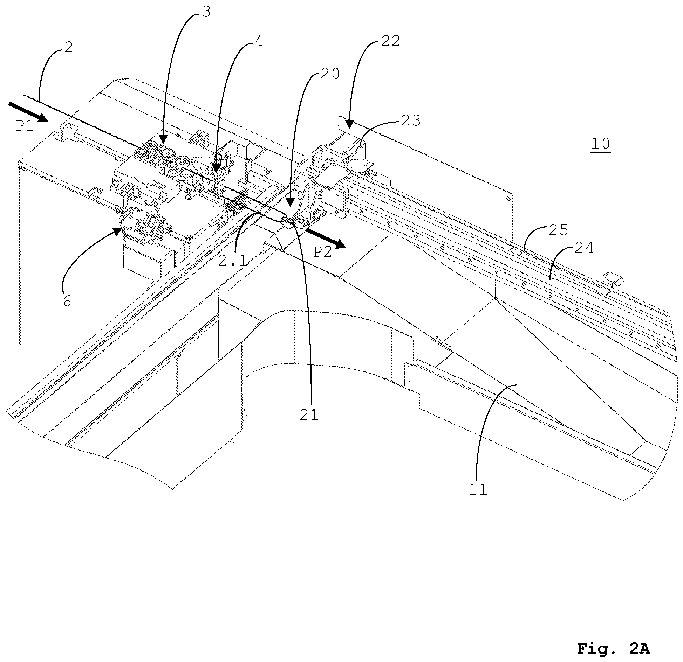

In Fig. 2A ist eine perspektivische Ansicht eines Teils einer Vorrichtung 10 mit Auszugsgreifer 20 gezeigt. Die Vorrichtung 10 ist zum Herstellen einer Kabelschlaufe 2.1 eines Kabelabschnitts ausgelegt.

Die Vorrichtung 10 umfasst Mittel 3, beispielsweise einen entsprechend ausgeführten Kabelantrieb 3, zum Einbringen und Halten eines nacheilenden Endes des Kabelabschnitts. Sie umfasst weiterhin Mittel 4, beispielsweise in Form eines Schlaufenlegers 4 analog zu Fig. 1. Der Schlaufenleger 4 fasst das voreilende Ende des Kabels 2 und legt die Kabelschlaufe 2.1 mit einer Schwenkbewegung (beispielsweise eine Drehung von 180°). Danach schiebt der Kabelantrieb 3 Kabel 2 vor bis die gewünschte Länge der Kabelschlaufe 2.1 erreicht ist bzw. die Kabelschlaufe 2.1 in der gewünschten Grösse ausgebildet ist.

Die Vorrichtung 10 umfasst zusätzlich einen sogenannten Auszugsgreifer 20. Der Auszugsgreifer 20 hat zwei Grundfunktionen. Einerseits dient der Auszugsgreifer 20 zum Umfassen eines Bereichs des Kabelabschnitts, der sich zwischen dem voreilenden und dem nacheilenden Ende des Kabelabschnitts befindet. Zu diesem Zweck weist der Auszugsgreifer 20 einen Greifer 21 auf. Andererseits hält der Auszugsgreifer 20 die Kabelschlaufe 2.1 straff, indem er sie in Längsrichtung auf wenig Zug beansprucht. Zu diesem Zweck umfasst der Auszugsgreifer 20 eine Bewegungsvorrichtung 22, die es ermöglicht, den Greifer 21 nach dem Umfassen relativ zu den Mitteln 3, 4 zu bewegen. Diese Bewegung erfolgt vorzugsweise in Richtung eines Pfeils P2, wie in Fig. 2A angedeutet. Die Bewegungsvorrichtung 22 kann aber auch eine Bewegung in eine andere Richtung, z.B. schräg oder entlang einer Kurvenbahn, ausführen, bei welcher der relative Abstand zwischen dem Schlaufenleger 4 und dem Greifer 21 vergrössert wird.

Vorzugsweise umfasst die Bewegungsvorrichtung 22 bei allen Ausführungsformen einen Motor 23. Besonders als Motor bevorzugt ist ein Servomotor 23. Die Bewegungsvorrichtung 22 des Auszugsgreifers 20 kann aber auch bewegungstechnisch an eine andere Bewegungsvorrichtung, beispielsweise an den Kabelantrieb 3, gekoppelt sein. In diesem Fall braucht der Auszugsgreifer 20 keinen eigenen Motor.

Vorzugsweise umfasst die Bewegungsvorrichtung 22 Ausführungsformen eine Linearachse 24 und einen Riemen 25, der von dem Motor 23 angetrieben wird. Besonders bevorzugt ist ein Zahnriemen 25. Der Riemen 25 überträgt eine Rotationsbewegung des Motors 23 auf den Greifer 21, damit dieser seine Position entlang der Linearachse 24 verändert.

Vorzugsweise umfasst die Vorrichtung 10 eine Kabelwanne 11, die unterhalb der Bewegungsvorrichtung 22 angeordnet ist, damit die Kabelschlaufen 2.1 nach dem Entdrillen in der Kabelwanne 11 abgelegt werden können.

Vorzugsweise ist der Auszugsgreifer 20 der Vorrichtung 10 so ausgelegt, dass er eine Linearachse aufweist, die eine Längsführung 24, einen Servomotor 23 und einen Zahnriemenantrieb mit Zahnriemen 25 umfasst, damit der Auszugsgreifer 20 parallel zur Kabeltransportrichtung P1 (d.h. parallel zu P2) verschiebbar ist.

Beim Transportieren der Kabelschlaufe 2.1 zur Entdrillvorrichtung 6 ist es besonders bei kurzen Kabelschlaufen 2.1 vorteilhaft, wenn der Auszugsgreifer 20 etwas in Richtung des Schlaufenlegers 4 zurückfährt. Ansonsten könnte die Kabelschlaufe 2.1 unter Umständen zu sehr gestreckt oder gar aus dem Auszugsgreifer 20 gerissen werden. Das Zurückfahren des Auszugsgreifer 20 geschieht vorzugsweise kurz vor dem Ausführen einer Querbewegung P3 der Transfereinheit 5 oder während des Ausführens einer Querbewegung P3 der Transfereinheit 5.

Fig. 2A zeigt den geschlossenen Auszugsgreifer 20 während des Ausziehens der sich verlängernden Kabelschlaufe 2.1.

Der Auszugsgreifer 20 ist so ausgebildet, dass er einen Abschnitt des Kabels 2 umgreift ohne ihn festzuklemmen.

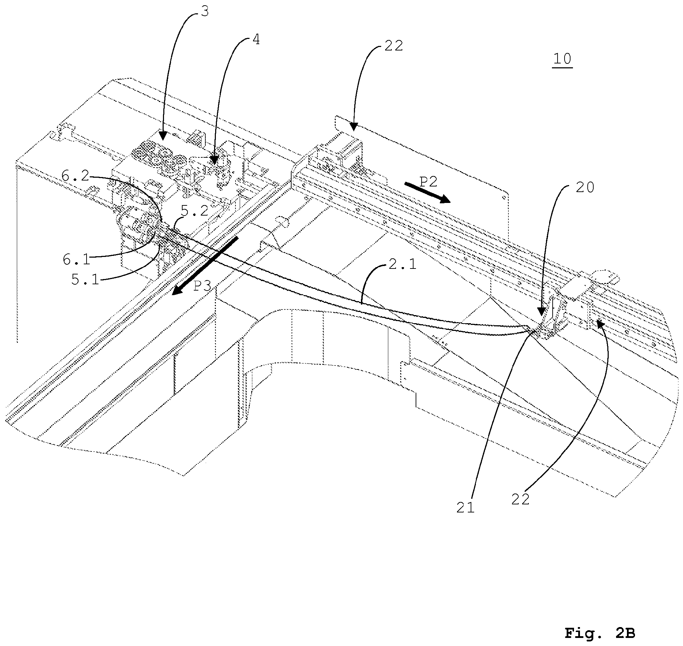

Vorzugsweise ist die Transfereinheit 5 bei allen Ausführungsformen mit zwei Kabelgreifern 5.1, 5.2 ausgestattet und kann auf einer rechtwinklig zur Kabeltransportrichtung angeordneten Führung (d.h. parallel zu P3) bewegt werden, um somit die beiden Kabelenden der Schlaufe 2.1 an zwei Kabelgreifer 6.1, 6.2 der Entdrillvorrichtung 6 zu übergeben. Fig. 2B zeigt die Situation nachdem die Kabelschlaufe 2.1 von der Transfereinheit 5 an die Entdrillvorrichtung 6 übergeben wurde.

Weiterhin ist in Fig. 2B zu erkennen, dass der Auszugsgreifer 20 den relativen Abstand zur Position des Schlaufenlegers 4 so vergrössert hat, dass die Kabelschlaufe 2.1 leicht straff ist. Zum Straffhalten ist die Steuerung der Bewegungen der Vorrichtung 10 so auslegt, das der Auszugsgreifer 20 stets eine leichte Zugspannung in Richtung P2 auf die Kabelschlaufe 2.1 ausübt.

Bei der in den Figuren 2A und 2B gezeigten Ausführungsform ergibt sich eine leichte Schrägstellung der Kabelschlaufe 2.1, da die Transfereinheit 5 in Bezug zum Auszugsgreifer 20 bei der Übergabe von dem Schlaufenleger 4 zur Entdrillvorrichtung 6 eine Querbewegung ausführt (P3 steht hier senkrecht zu P2).

Die Anordnung der Achsen kann auch anders sein. So kann die Linearachse des Auszugsgreifers 20 beispielsweise schräg verlaufen, oder der Auszugsgreifer 20 kann einer bogenförmigen Bahn folgen.

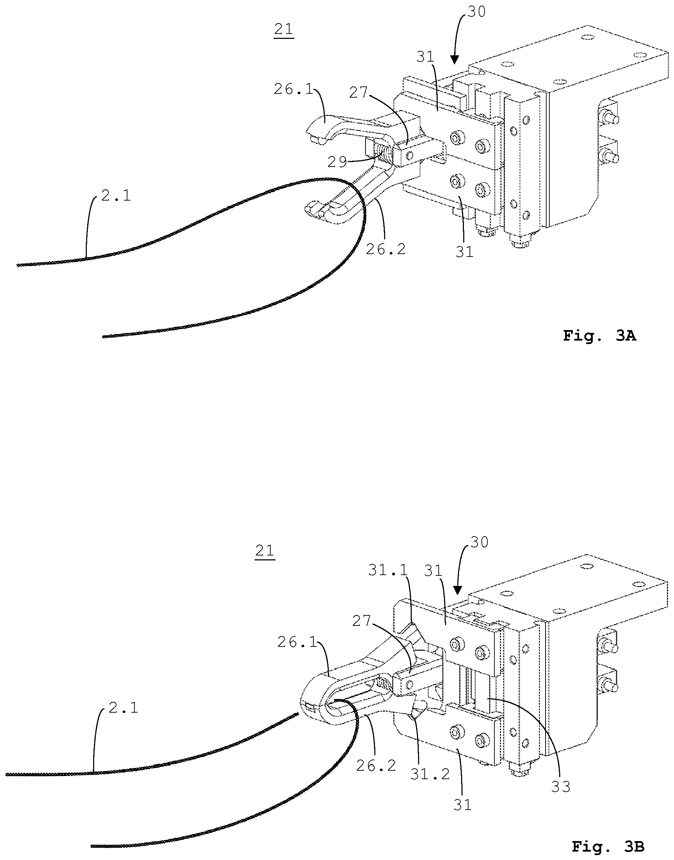

Der Auszugsgreifer 20 verfügt vorzugsweise über zwei Greiferfinger 26.1, 26.2, die durch Drehen um einen, in einem Gabelstück 27 angeordneten Bolzen 28, geschlossen bzw. geöffnet werden können. Entsprechende Details einer bevorzugten Ausführungsform sind in den Figuren 3A bis 3E gezeigt.

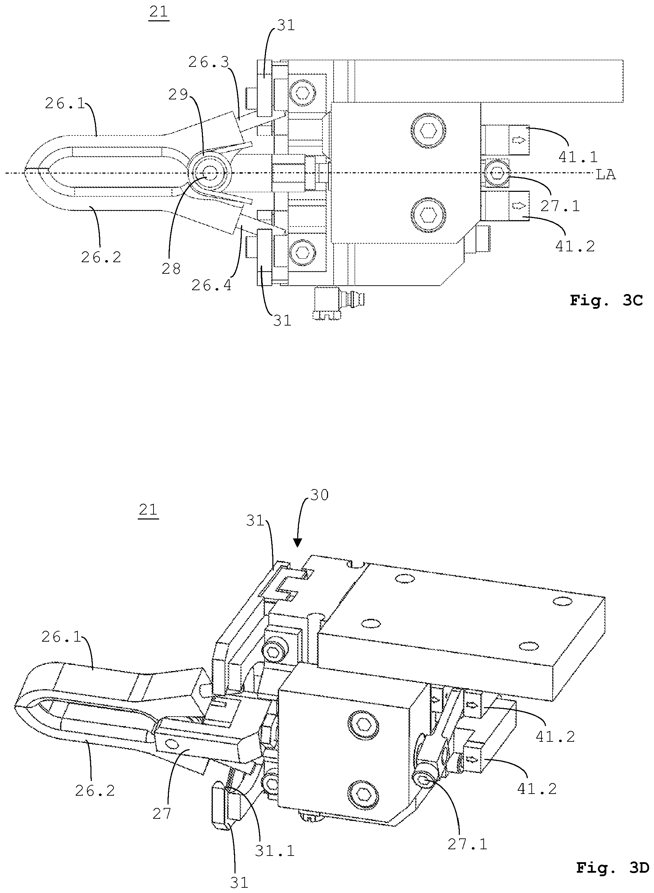

Beim der dargestellten Ausführungsform erfolgt das Schliessen der Greiferfinger 26.1, 26.2 durch eine auf diesem Bolzen 28 angeordnete Schenkelfeder 29 (siehe z.B. Fig. 3C). Die Schenkelfeder 29 beaufschlagt die rückwärtigen Enden der Greiferfinger 26.1, 26.2 mit einer Schliesskraft. Im Normalzustand sind die Greiferfinger 26.1, 26.2 somit geschlossen.

Das Öffnen des Auszugsgreifers 20, d.h. das Überführen in einen geöffneten Zustand, erfolgt durch die gegenläufige Bewegung von zwei Greiferbacken 31 eines pneumatischen, hydraulischen oder motorangetriebenen Parallelgreifers 30, der im Bereich des Gabelstücks 27 angeordnet ist. Die Greiferbacken 31 verfügen vorzugsweise über V-förmige Ausnehmungen 31.1, 31.2, die beim Schliessen des Parallelgreifers 30 auf die an den Enden der Greiferfinger 26.1, 26.2 angeordneten Stifte 26.3, 26.4 drücken und somit das Öffnen des Auszugsgreifers 20 bewirken. Der Parallelgreifer 30 umfasst vorzugsweise eine Führung 33 (siehe Fig. 3B), die zum linearen Führen der Greiferbacken 31 dient.

Die Greiferfinger 26.1, 26.2 des Auszugsgreifers 20 und das Gabelstück 27 an denen sie befestigt sind, können sich um eine Längsachse LA (parallel zur Richtung der Auszugsbewegung P2) innerhalb eines bestimmten Winkels frei drehen. Vorzugsweise beträgt dieser Winkel bei allen Ausführungsformen weniger als 90 Grad, um ein Überwerfen der Kabelschlaufe 2.1 zu verhindern.

Die v-förmigen Ausnehmungen 31.1, 31.2 der Greiferbacken 31 des Parallelgreifers 30 bewirken, dass die Greiferfinger 26.1, 26.2 beim geöffneten Zustand des Auszugsgreifers 20 senkrecht stehen, wie in Fig. 3A gezeigt.

Diese Stellung bleibt beim Schliessen der Greiferfinger 26.1, 26.2 erhalten, bis die Kabelschlaufe 2.1 kein Drehmoment mehr auf den Auszugsgreifer 20 ausübt. Falls ein Drall in der Kabelschlaufe 2.1 vorliegt, drehen sich die Greiferfinger 26.1, 26.2 in die eine oder andere Richtung. Diese Drehbewegung wird bei dem erwähnten Winkel, der maximal 90 Grad beträgt, gestoppt.

Die Drehung des Gabelstückes 27 ist zu diesem Zweck durch Anschläge begrenzt. Besonders bevorzugt ist eine Ausführungsform, bei der die Anschläge so ausgebildet und pösitioniert sind, dass der maximale Winkel 70 Grad beträgt.

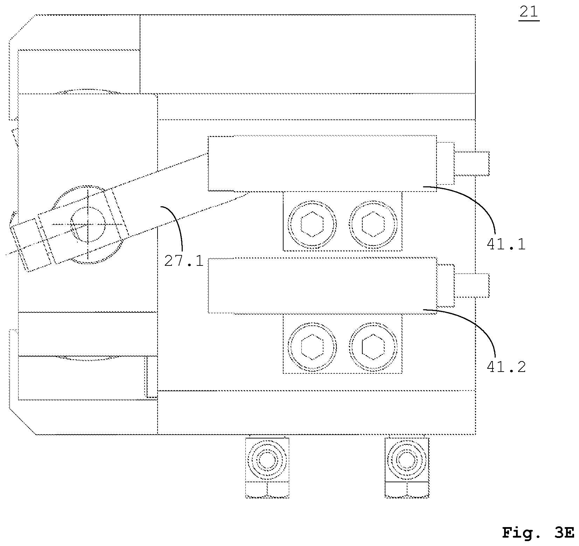

Am Ende des Gabelstückes 27 kann bei einer bevorzugten Ausführungsform eine Schaltfahne 27.1 befestigt sein, die eine erste und eine zweite (Gabel-)Lichtschranke 41.1,41.2 unterbrechen kann. Entsprechende Details sind in Fig. 3D und Fig. 3E gezeigt. Die Bewegung der Schaltfahne 27.1 ist mit der Drehbewegung des Greifers 21 um die Achse LA gekoppelt.

Durch diese Anordnung kann die senkrechte Stellung der Greiferfinger 26.1, 26.2 (in dieser senkrechten Stellung ist keine der (Gabel-)Lichtschranken 41,1,41.2 unterbrochen) oder eine der beiden schrägen Endstellungen detektiert werden. Bei jeder der beiden schrägen Endstellungen ist nur eine der beiden Lichtschranken 41.1,41.2 unterbrochen. Eine solche schräge Endstellung ist in Fig. 3D zu erkennen. Die senkrechte Stellung ist z.B. in den Figuren 3A und 3B gezeigt.

Eine Sensoreinrichtung mit der ersten und zweiten (Gabel-) Lichtschranke 41.1,41.2 stellt eine besonders kostengünstige und gleichzeitig eine besonders robuste Variante dar.
Die beiden (Gabel-)Lichtschranken 41 liefern je nach Zustand (durch die Schaltfahne 27.1 unterbrochen oder nicht) ein digitales Signal, welches direkt einer Maschinensteuerung der Vorrichtung 10 oder Kabelbearbeitungsmaschine 1 zur Verfügung gestellt wird, um die Entdrillvorrichtung 6 zu steuern. Es ist ein Nachteil dieser Sensoreinrichtung, dass keine Zwischenwerte der Verdrehung des Kabelgreifers 21 gemessen oder ermittelt werden können und dass auch die senkrechte Stellung der Greiferfinger 26.1, 26.2 nur ungefähr bestimmt werden kann, wenn nämlich beide Lichtschranken 41 nicht unterbrochen sind. Dies Art der Sensoreinrichtung ist jedoch für die vorliegenden Anwendungen ausreichend.

Andere Ausführungsformen lassen sich realisieren, wenn anstelle der Lichtschranken 41.1,41.2 z.B. kapazitive oder induktive Näherungsschalter eingesetzt werden würden, die z.B. ebenfalls die Anwesenheit, der Schaltfahne 27.1 bei einer bestimmten Winkelstellung als digitales Signal ausgeben würden.

Soll die Winkelstellung der Greiferfinger 26.1, 26.2 genauer erfasst werden, werden eine andere Sensoreinrichtung mit andere Sensoren eingesetzt, die z.B. direkt die Verdrehung der Längsachse LA bzw. des Gabelstückes 27 messen können. Dafür bieten sich beispielsweise Drehpotentiometer an, die einen analogen Spannungswert in Abhängigkeit vom Drehwinkel liefern, oder es können Absolutwert-Drehgeber eingesetzt werden. Diese Sensoreinrichtung liefern dann den Winkelwert direkt als digitales Ausgangssignal an eine Maschinensteuerung der Vorrichtung 10 oder Kabelbearbeitungsmaschine 1.

Die Sensoren 41.1,41.2 sind (unabhängig davon, ob es sich um optische, kapazitive, induktive Sensoren, oder ein Drehpotentiometer oder einen Absolutwert-Drehgeber handelt) Teil der Sensoreinrichtung.

Die Sensorvorrichtung ist vorzugsweise bei allen Ausführungsformen so ausgelegt und aufgebaut, dass sie auch Information über die Richtung des Dralls in der Kabelschlaufe 2.1 erfassen kann. Diese Information ist vorteilhaft, um den Entdrillvorgang in die korrekte Richtung starten zu können. Daher wird die Information über die Richtung des Dralls von der Sensorvorrichtung an eine Maschinensteuerung der Vorrichtung 10 oder Kabelbearbeitungsmaschine 1 weitergeleitet. Zur Ermittlung der Richtung des Dralls kann aber auch eine separate Sensorvorrichtung eingesetzt werden, die unabhängig von der Sensorvorrichtung arbeitet.

Vorzugsweise basiert die Drallmessung (d.h. die Messung des Dralls und/oder die Ermittlung der Richtung des Dralls und/oder die Ermittlung des drallfreien Zustands) darauf, dass in dem Auszugsgreifer 20 Greiferfinger 26.1, 26.2 zum Einsatz kommen, die drehbar um die Längsachse LA gelagerte sind. Die Lagerung der Greiferfinger 26.1, 26.2 an einem drehbaren Gabelstück 27 ist besonders bevorzugt.

Je nach Ausführungsform kann entweder zuerst ein Kabelabschnitt von einem Kabel 2 abgetrennt und dann von den Mitteln 3, 4 (z.B. im Zusammenspiel eines Kabelantriebs 3 und eines Schlaufenlegers 4) gefasst und im Zusammenwirken mit dem Auszugsgreifers 20 zu einer Schlaufe 2.1 geformt werden, oder es wird die Schlaufe 2.1 zeitgleich gebildet, während das Kabel 2 von dem Kabelantrieb 3 in die Vorrichtung 10 eingeschoben oder gezogen wird, wie in Fig. 2A gezeigt.

Der Greifer 21 umfasst das Kabel 2 der Kabelschlaufe 2.1 nach der Schlaufenlegung.

Besonders bevorzugt sind Ausführungsformen, bei denen der Greifer 21 dass Kabel 2 der Kabelschlaufe 2.1 am Anfang der Schlaufenbildung umfasst, wie in Fig. 2A gezeigt. Diese Ausführungsform liefert besonders gute Ergebnisse in Sachen Reproduzierbarkeit und Produktivität, da die Kabelschlaufe 2.1 stets unter leichter Zugspannung gehalten werden kann, um das Überwerfen zu verhindern. Die Kabelschlaufe 2.1 wird beim Bilden mittels der Bewegungsvorrichtung 22 gespannt ausgezogen.

Falls der Greifer 21 das Kabel 2 der Kabelschlaufe 2.1 vor oder während der Schlaufenbildung umfasst, wird der Greifer 21 durch die Bewegungsvorrichtung 22 synchron zum Ausbilden der Schlaufe 2.1 bewegt. Besonders bevorzugt sind Ausführungsformen, bei denen die Bewegungsvorrichtung 22 eine lineare Bewegung des Greifers 21 in Längsrichtung der Schlaufe 2.1 ausführt, die in etwa der halben Geschwindigkeit des Kabels 2 in Richtung P1 entspricht. Wenn das Kabel 2 in Richtung P1 eine Geschwindigkeit v1 aufweist, dann beträgt die Geschwindigkeit v2 des Greifers 21 in Richtung P2 in etwa v1/2.

Vorzugsweise erfolgt eine Überwachung des Dralls der Schlaufe 2.1 (Drallermittlung genannt) und/oder eine Überwachung, die es ermöglicht eine Aussage darüber zu treffen, ob der Drall erfolgreich beseitigt wurde (Ermittlung des drallfreien Zustands genannt). Die Drallermittlung und/oder die Ermittlung des drallfreien Zustands kann am Auszugsgreifer 20, vorzugsweise am Greifer 21 selbst, erfolgen (z.B. mit einer Sensoreinrichtung, wie bereits erwähnt), oder sie kann mittels einer separaten Sensoreinrichtung erfolgen.

Eine separate Sensoreinrichtung kann z.B. eine CCD-Kamera zusammen mit einer Mustererkennungssoftware Umfassen, die in der Lage ist eine Aufnahme der CCD-Kamera digital auszuwerten und anhand der Auswertung (z.B. durch einen Mustervergleich mit zuvor gespeicherten Bildern) eine Aussage über den momentanen Drall inklusiver Drallrichtung zu ermöglichen. Eine solche Sensoreinrichtung auf CCD-Basis kann auch den drallfreien Zustand anhand eines solchen Mustervergleichs erkennen.

Es sind verschiedene alternative Ausführungen des Auszugsgreifes 20 möglich, die im Zusammenhang mit den verschiedenen beschriebenen Ausführungsformen zum Einsatz kommen können.

Die Funktionalität des Auszugsgreifers 20 lässt sich z.B. auch durch alternative Konstruktionen erreichen. So kann beispielsweise:
- das Schliessen und Öffnen der Greiferfinger 26.1, 26.2 direkt pneumatisch, hydraulisch oder motorangetrieben erfolgen;
- das Senkrechtstellen der Greiferfinger 26.1, 26.2 durch ein Teil erfolgen, das seitwärts an das Gabelstück 27 gedrückt wird;
- das Senkrechtstellen der Greiferfinger 26.1, 26.2 durch Zugfedern erfolgen;
- das Senkrechtstellen der Greiferfinger 26.1, 26.2 durch ein Elektromagnet erfolgen;
- die Winkellage der Greiferfinger 26.1, 26.2 durch einen (Winkel-)Encoder gemessen werden.

Die erfindungsgemässe Vorrichtung 10 lässt sich auch im Zusammenhang mit Maschinen verwenden, bei denen die Kabelschlaufen 2.1 auf andere Art gebildet wird, wie dies beispielsweise in der eingangs erwähnten Patentanmeldung EP0883917 für eine Kabelbearbeitungsmaschine nach dem Schwenkarmprinzip offenbart ist.

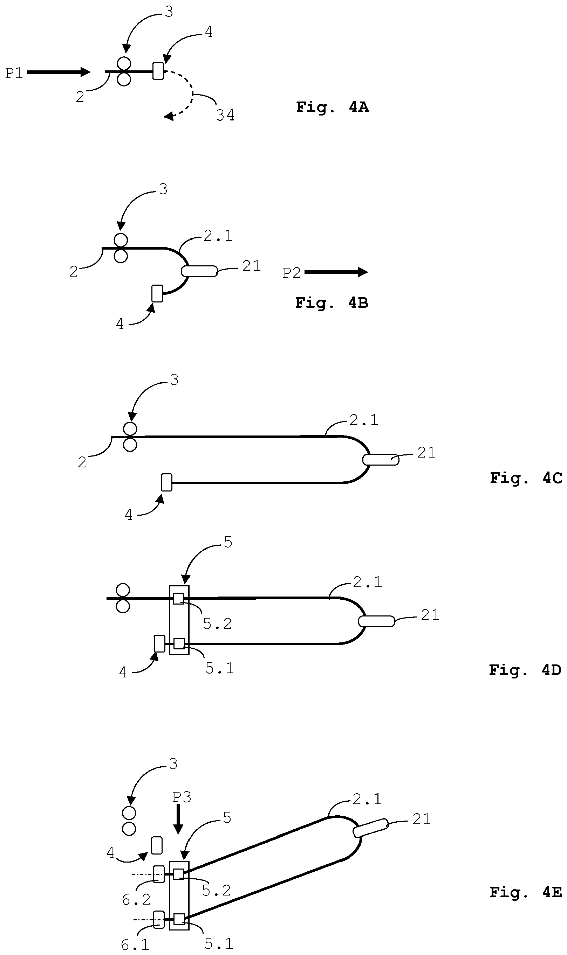

Anhand der stark schematisierten Prinzipskizzen der Figuren 4A - 4E, werden im Folgenden beispielhafte Details des Verfahrens zum Bilden einer Kabelschlaufe 2.1 beschrieben.

In einem ersten Schritt wird ein Kabel 2 in eine Vorrichtung 10 eingebracht, die zu diesem Zweck einen Kabelantrieb 3 (hier durch zwei Rollen symbolisiert) umfasst. Das vorauseilende Ende des Kabels 2 kann von dem Greifer eines Schlaufenlegers 4 erfasst werden. Der Schlaufenleger 4 ist so ausgebildet, dass er eine Schwenkbewegung entlang einer Bahn 34 ausführen kann. Beim Ausführen dieser Schwenkbewegung vollzieht der Greifer des Schlaufenlegers 4 beispielsweise eine 180 Grad Drehung. Auf diese Art und Weise wird die Kabelschlaufe 2.1 gelegt.

Nach dem Legen der Kabelschlaufe 2.1 umfasst der Greifer 21 die Kabelschlaufe 2.1. Dieser Zustand ist in Fig. 4B gezeigt. Zu diesem Zweck wird der Greifer 21 des Auszugsgreifers 20 zuvor in den geöffneten Zustand überführt (wie z.B. in Fig. 3A gezeigt). Dann umgreift der Greifer 21 das Kabel 2 der Kabelschlaufe 2.1 und der Greifer 21 wird in einen geschlossenen Zustand, in dem er den Kabelbereich lose umschliesst, überführt. Dieser Zustand ist z.B. in Fig. 3B gezeigt.

Nun wird eine Relativbewegung P2 des Auszugsgreifers 20 in Bezug zu dem Kabelantrieb 3 und dem Schlaufenleger 4 ausgeführt, um während des Bildens der Kabelschlaufe 2.1 die Kabelschlaufe 2.1 in Längsrichtung auf leichten Zug zu beanspruchen. Der Endzustand dieser Auszugsbewegung ist in Fig. 4C gezeigt.

Nun werden die beiden Enden der Kabelschlaufe 2.1 an die Greifer 5.1, 5.2 der Transfereinheit 5 übergeben. Dieser Moment ist in Fig. 4D angedeutet.

Dann wird eine Querbewegung P3 ausgeführt, um die beiden Enden der Kabelschlaufe 2.1 an die Greifer 6.1, 6.2 der Entdrillvorrichtung 6 zu übergeben. Dieser Moment ist in Fig. 4E angedeutet.

Nun kommt ein Verfahren zum Entdrillen der Kabelschlaufe 2.1 zur Anwendung. Die Richtung und/oder Anzahl von Entdrilldrehungen wird aus dem detektierten Drall abgeleitet. Die Entdrilldrehung erfolgt um die Kabellängsachse. Beim Ausführen der Entdrilldrehung dreht sich entweder nur einer der beiden Greifer 6.1 oder 6.2 der Entdrillvorrichtung 6, oder es drehen sich beide Greifer 6.1 oder 6.2 entgegengesetzt.

Vorzugsweise wird eine Sensoreinrichtung eingesetzt, um den drallfreien Zustand der Kabelschlaufe 2.1 zu detektieren. Sobald der drallfreie Zustand detektiert wurde, kann das Verfahren zum Entdrillen beendet werden. Falls keine Detektion des drallfreien Zustands zum Einsatz kommt, wird das Verfahren zum Entdrillen beendet, nachdem eine vorbestimmte Anzahl von Entdrilldrehungen ausgeführt wurde.

## Patentansprüche

1. Vorrichtung (10) zum Bilden einer Kabelschlaufe (2.1) eines Kabelabschnitts, wobei die Vorrichtung (10) einen Kabelantrieb (3) zum Vorschieben eines Kabels (2) und einen Schlaufenleger (4) zum Greifen eines ersten Endes des Kabels (2) und zum Legen einer Kabelschlaufe (2.1) umfasst, wobei beim Vorschieben des Kabels (2) die Kabelschlaufe (2.1) zu einer gewünschten Grösse ausgebildet wird,
**dadurch gekennzeichnet,**
**dass** die Vorrichtung (10) zusätzlich einen Auszugsgreifer (20) aufweist, wobei der Auszugsgreifer (20) das Kabel (2) der Kabelschlaufe (2.1) umfasst und nach dem Umfassen des Kabels (2) der Kabelschlaufe (2.1) relativ zum Schlaufenleger (4) bewegbar ist und dabei die Kabelschlaufe (2.1) in Längsrichtung spannt und wobei ein Greifer (21) des Auszugsgreifers (20) mit einer Sensoreinrichtung versehen ist, die den Drall in der Kabelschlaufe (2.1) und/oder eine Richtung des Dralls und/oder einen drallfreien Zustand der Kabelschlaufe (2.1) detektiert.

2. Vorrichtung (10) nach Anspruch 1,
**dadurch gekennzeichnet,**
**dass** die Sensoreinrichtung so ausgelegt ist, dass der Drall in der Kabelschlaufe (2.1) durch die Sensoreinrichtung und/oder eine Richtung des Dralls und/oder ein drallfreier Zustand der Kabelschlaufe (2.1) berührungslos detektierbar sind.

3. Vorrichtung (10) nach einem der vorhergehenden Ansprüche,
**dadurch gekennzeichnet,**
**dass** der Greifer (21) zwei Greiffinger (26.1, 26.2) umfasst, die zum Umfassen des Kabels (2) der Kabelschlaufe (2.1) in einen geöffneten Zustand überführbar sind.

4. Vorrichtung (10) nach Anspruch 2,
**dadurch gekennzeichnet,**
**dass** der Greifer (21) zwei Greiferbacken (31) umfasst, die pneumatisch, hydraulisch oder motorangetrieben entlang einer Führung (33) so verschiebbar sind, dass sich durch diese Verschiebung der Greiferbacken (31) die Greiffinger (26.1, 26.2) in den geöffneten Zustand überführen lassen.

5. Vorrichtung (10) nach Anspruch 3 oder 4,
**dadurch gekennzeichnet,**
**dass** die Greiffinger (26.1, 26.2) in einem Gabelstück (27) gelagert sind, das um eine Längsachse (LA) drehbar gelagert ist.

6. Vorrichtung (10) nach einem der vorhergehenden Ansprüche 1 - 5,
**dadurch gekennzeichnet,**
**dass** der Greifer (21) zwei Greiffinger (26.1, 26.2) umfasst, die in einem Gabelstück (27) gelagert sind, das um eine Längsachse (LA) drehbar gelagert ist.

7. Verfahren zum Bilden einer Kabelschlaufe (2.1) eines Kabelabschnitts, mit den folgenden Schritten:
- Umfassen eines Kabels (2) der Kabelschlaufe (2.1) mit einem geöffneten Greifer (21) eines Auszugsgreifers (20),
- Überführen des Greifers (21) in einen geschlossenen Zustand, in dem der Greifer (21) das Kabel (2) der Kabelschlaufe (2.1) lose umschliesst,
- Ausführen einer Relativbewegung (P2) zum Spannen der Kabelschlaufe (2.1) während des Bildens der Kabelschlaufe (2.1),
Einsatz einer Sensoreinrichtung, um den Drall in der Kabelschlaufe (2.1) und/oder eine Richtung des Dralls der Kabelschlaufe und/oder einen drallfreien Zustand der Kabelschlaufe (2.1) zu detektieren.

8. Verfahren nach Anspruch 7,
**dadurch gekennzeichnet,**
**dass** nach dem Ermitteln des Dralls in der Kabelschlaufe (2.1) ein Verfahren zum Entdrillen der Kabelschlaufe (2.1) zur Anwendung kommt und wobei die Richtung und/oder Anzahl von Entdrilldrehungen aus dem detektierten Drall abgeleitet wird.

9. Verfahren nach Anspruch 7 oder 8, mit den folgenden Schritten:
- Kabelschlaufe (2.1) mit einer Querbewegung (P3) einer Entdrillvorrichtung (6) zuführen,
- Zurückfahren des Auszugsgreifers (20) vor oder während des Ausführens der Querbewegung (P3).

## Claims

1. Device (10) for forming a cable loop (2.1) of a cable section, wherein the device (10) comprises a cable actuator (3) for advancing a cable (2) and a loop-layer (4) for gripping a first end of the cable and forming a cable loop (2.1), wherein on advancing the cable (1) the cable loop (2.1) can be formed to a desired size,
**characterised in that**
the device (10) also comprises a pull-out gripper(20), wherein the pull-out gripper (20) grasps the cable (2) of the cable loop (2.1) and after grasping the cable (2) of the cable loop (2.1) can be moved relative to loop former (4) and thereby tensions the cable loop (2.1) in the longitudinal direction and wherein a gripper (21) of the pull-out gripper(20) is provided with a sensor device which detects the twist in the cable loop (2.1) and/or a direction of the twist and/or a twist-free state of the cable loop (2.1).

2. Device (10) according to claim 1
**characterised in that**
the sensor device is designed in such a way that through the sensor device the twist in the cable loop (2.1) and/or a direction of the twist and/or a twist -free state of the cable loop (2.1) can be detected in a contactless manner.

3. Device (10) according to any one of the preceding claims
**characterised in that**
the gripper (21) comprises two gripping fingers (26.1, 26.2) which can be moved into an open position in order to grasp the cable (2) of the cable loop (2.1).

4. Device (10) according to claim 2
**characterised in that**
the gripper (21) comprises two gripping jaws (31) which can be displaced in a pneumatic, hydraulic or motor-driven manner along a guide (33) in such a way that through this displacement of the gripping jaws (31) the gripping fingers (26.1, 26.2) are transferrable into the open state.

5. Device (10) according to claim 3 or 4
**characterised in that**
the gripping fingers (26.1, 26.2) are borne in a forked section (27) which is borne in rotational manner about a longitudinal axis (LA).

6. Device (10) according to any one of the preceding claims 1-5
**characterised in** tht
the gripper(21) comprises two gripping fingers (26.1, 26.2) which are borne in a forked section (27) which is borne in a rotational manner about a longitudinal axis (LA).

7. Method of forming a cable loop (2.1) of a cable section with the following steps:
- grapsing a cable (2) of the cable loop (2.1) with an open gripper (21) of an pull-out gripper(20),
- transferring the gripper (21) into a closed state in which the gripper (21) loosely grasps the cable (2) of the cable loop (2.1),
- carrying out of a relative movement (P2) to tension the cable loop (2.1) during the formation of the cable loop (2.1),
use of a sensor device to detect the twist in the cable loop (2.1) and/or a direction of the twist of the cable loop and/or a twist-free state of the cable loop (2.1).

8. Method according to claim 7
**characterised in that**
after determining the twist in the cable loop (2.1) a method of untwisting the cable loop (2.1) is used and wherein the direction and/or number of untwisting rotations is derived from the detected torsion.

9. Method according to claim 7 or 8 with the following steps:
- supplying a cable loop (2.1) to an untwisting device (6) with a transverse movement (P3),
- retracting the pull-out gripper(20) before or during the implementation of the transverse movement (P3).

## Revendications

1. Dispositif (10) pour former une boucle de câble (2.1) d'un tronçon de câble, étant précisé que le dispositif (10) comprend un entraînement de câble (3) pour faire avancer un câble (2), et un dispositif de pliage en boucle (4) pour saisir une première extrémité du câble (2) et pour plier une boucle de câble (2.1), et que lors de l'avance du câble (2), la boucle de câble (2.1) est formée suivant une taille voulue,
**caractérisé en ce que** le dispositif (10) comporte en supplément une pince d'étirage (20), étant précisé que la pince d'étirage (20) enserre le câble (2) de la boucle de câble (2.1) et, après avoir enserré le câble (2) de ladite boucle (2.1), est mobile par rapport au dispositif de pliage en boucle (4) en tendant la boucle (2.1) dans le sens longitudinal, une pince (21) de la pince d'étirage (20) étant pourvue d'un dispositif de détection qui détecte la torsion dans la boucle de câble (2.1) et/ou détecte un sens de la torsion et/ou un état sans torsion de la boucle de câble (2.1).

2. Dispositif (10) selon la revendication 1, **caractérisé en ce que** le dispositif de détection est conçu pour que la torsion dans la boucle de câble (2.1) soit détectable par le dispositif de détection et/ou qu'un sens de la torsion et/ou un état sans torsion de la boucle de câble (2.1) soit détectable sans contact.

3. Dispositif (10) selon une des revendications précédentes, caractérisé en ce la pince (21) comprend deux doigts de préhension (26.1, 26.2) qui, pour enserrer le câble (2) de la boucle de câble (2.1), peuvent être passés dans un état ouvert.

4. Dispositif (10) selon la revendication 2, **caractérisé en ce que** la pince (21) comprend deux mâchoires de préhension (31) qui peuvent être déplacées par système pneumatique, hydraulique ou par entraînement motorisé le long d'un guide (33) de manière à ce que, du fait de ce décalage des mâchoires de préhension (31), les doigts de préhension (26.1, 26.2) soient passés dans l'état ouvert.

5. Dispositif (10) selon la revendication 3 ou 4, **caractérisé en ce que** les doigts de préhension (26.1, 26.2) s'appuient dans une pièce en fourche (27) qui s'appuie en rotation autour d'un axe longitudinal (LA).

6. Dispositif (10) selon l'une des revendications précédentes, **caractérisé en ce que** la pince (21) comprend deux doigts de préhension (26.1, 26.2) qui s'appuient dans une pièce en fourche (27) qui s'appuie en rotation autour d'un axe longitudinal (LA).

7. Procédé pour former une boucle de câble (2.1) d'un tronçon de câble, avec les étapes qui consistent :
- à enserrer un câble (2) de ladite boucle de câble (2.1) avec une pince ouverte (21) d'une pince d'étirage (20),
- à amener la pince (21) dans une position fermée dans laquelle elle entoure de manière lâche le câble (2) de la boucle de câble (2.1),
- à décrire un mouvement relatif (P2) pour tendre la boucle de câble (2.1) pendant la formation de ladite boucle de câble (2.1),
- utilisation d'un dispositif de détection pour détecterla torsion dans la boucle de câble (2.1) et/ou un sens de la torsion de la boucle de câble et/ou un état sans torsion de la boucle de câble (2.1).

8. Procédé selon la revendication 7, **caractérisé en ce que**, après que la torsion dans la boucle de câble (2.1) a été déterminée, un procédé pour détordre la boucle de câble (2.1) est utilisé, étant précisé que le sens et/ou le nombre de tours de détorsion sont déduits de la torsion détectée.

9. Procédé selon la revendication 7 ou 8, avec les étapes qui consistent :
- à amener la boucle de câble (2.1) avec un mouvement transversal (P3) dans un dispositif de détorsion (6),
- à ramener la pince d'étirage (20) avant ou pendant l'exécution du mouvement transversal (P3).
